# EUROPÄISCHE PATENTSCHRIFT

(11) **EP 3 374 132 B1**
(45) Veröffentlichungstag und Bekanntmachung des Hinweises auf die Patenterteilung: **21.07.2021**
(21) Anmeldenummer: 16840370.7
(22) Anmeldetag: 14.11.2016
(51) Int. Cl.: B25B 27/02, B25B 27/14, H01L 21/48

(54) **VORRICHTUNG ZUM ENTFERNEN VON BAUELEMENTEN VON ANDEREN BAUELEMENTEN**
DEVICE FOR REMOVING COMPONENTS FROM OTHER COMPONENTS
DISPOSITIF PERMETTANT D'ENLEVER DES COMPOSANTS SITUÉS SUR D'AUTRES COMPOSANTS

(30) Priorität: 14.11.2015 DE 202015007872 U
(43) Veröffentlichungstag der Anmeldung: 19.09.2018
(73) Patentinhaber: Hartung, Roman, 13581 Berlin (DE)
(72) Erfinder: Hartung, Roman, 13581 Berlin (DE)
(74) Vertreter: Maikowski & Ninnemann Patentanwälte Partnerschaft mbB
(86) Internationale Anmeldenummer: PCT/EP2016/077580
(87) Internationale Veröffentlichungsnummer: WO 2017/081317

(56) Entgegenhaltungen:
- DE-U1-202004 008 143
- US-A1- 2013 067 708

## Beschreibung

Die Erfindung betrifft eine Vorrichtung zum Entfernen von Bauelementen von anderen Bauelementen mit den Merkmalen des Anspruchs 1 und ein Verfahren zum Entfernen von Bauelementen von anderen Bauelementen mit den Merkmalen des Anspruchs 14.

Insbesondere betrifft die Erfindung eine Vorrichtung und ein Verfahren zum Entfernen von Wärmeleitabdeckungen, zum Beispiel integrierten Wärmeleitabdeckungen, sogenannten "integrated heatspreader", von Mikroprozessoren. Unter Entfernen wird das Lösen eines Bauteils vom anderen verstanden unter Ablösung der Klebeverbindung.

Bauelemente, wie z.B. Mikroprozessoren werden speziell im PC-Bereich mit integrierten Wärmeleitabdeckungen ausgeliefert. Diese Abdeckung schützt den Mikroprozessor und gewährleistet eine bessere Wärmeverteilung in Richtung des Kühlkörpers. Zwischen Wärmeleitabdeckung und Substrat des Mikroprozessors befindet sich Wärmeleitpaste. Diese Wärmeleitpaste trocknet nach längerem Betrieb aus und muss ersetzt werden. Dafür muss die Wärmeleitabdeckung entfernt werden, welche fest mit dem Mikroprozessor verklebt ist.

Nach Stand der Technik werden Wärmeleitabdeckungen entweder mit einem handelsüblichen Schraubstock oder einer dünnen Klinge entfernt. Beim Einlegen des Mikroprozessors in den Schraubstock kann die Platine leicht verbogen werden, wodurch der Mikroprozessor permanent beschädigt wird. Auch das Entfernen durch die dünne Klinge bietet große Risiken, da leicht Leiterbahnen in der Platine durchtrennt werden können. Hinzu kommt, dass die bisherige Methode mit der Klinge sehr zeitintensiv ist. Nach dem Tauschen der Wärmeleitpaste muss die Wärmeleitabdeckung wieder verklebt werden. Hierzu wurde üblicherweise der Mikroprozessor wieder in den Sockel gesetzt, um die Wärmeleitabdeckung so genau wie möglich zu platzieren.

Das Entfernen kann somit zeitintensiv sein und leicht zu einer Beschädigung eines Bauelements, zum Beispiel des Mikroprozessors, führen, da der Druck unkontrolliert aufgebracht wird.

Ein Aspekt der Erfindung betrifft eine Vorrichtung zum Entfernen mindestens einer Wärmeleitabdeckung von jeweils einem Mikroprozessor, der ein Substrat und eine Wärmeleitabdeckung aufweist, wie in Anspruch 1 offenbart.

Gemäß einer ersten Alternative weist das Positionierungsmittel ein Bauelement auf und der mindestens eine Mikroprozessor ist zwischen dem Positionierungsmittel und dem Druckübertragungsmittel lösbar fixiert. Dadurch kann die Zahl der Komponenten reduziert werden, da das Positionierungsmittel einteilig ausgeführt werden kann und trotzdem eine formschlüssige lösbare Fixierung des Mikroprozessors mit Substrat und Wärmeleitabdeckung in allen Freiheitsgraden möglich ist.

Alternativ hierzu umfasst das Positionierungsmittel mindestens zwei lösbar miteinander verbindbare Bauelemente und der mindestens eine Mikroprozessor ist zwischen den Bauelementen fixierbar, wenn die Bauelemente miteinander verbunden sind. Dadurch kann eine besonders sichere formschlüssige lösbare Fixierung des Mikroprozessors mit Substrat und Wärmeleitabdeckung in allen Freiheitsgraden erreicht werden.

Dazu können die Bauelemente ausgelegt sein, das Druckübertragungsmittel zwischen beiden Bauelementen zu führen, wobei das Druckübertragungsmittel sich insbesondere in einer Aussparung eines Bauelements befindet, wenn die Vorrichtung zusammengesetzt ist. Dadurch wird die Führung des Druckübertragungsmittels konstruktiv vereinfacht.

Die Führung hat den Effekt, dass der Druck kontrolliert in Richtung und/oder Stärke aufgebracht werden kann.

Insbesondere kann der Druck in einer Richtung aufgebracht werden kann, die im Wesentlichen parallel zur Oberfläche des Substrats des mindestens einen Mikroprozessors verläuft. Die dadurch entstehenden Scherkräfte ermöglichen ein optimales Entfernen und vermeiden dabei eine Beschädigung von Mikroprozessor und Substrat. Dabei ist insbesondere die Führung ausgelegt, das Druckübertragungsmittel in einer Richtung im Wesentlichen parallel zur Oberfläche des Substrats des mindestens einen Mikroprozessors zu führen.

Insbesondere kann das Positionierungsmittel die Führung aufweisen. Dadurch ist die Richtung, in die der Druck übertragen werden kann, relativ zum Mikroprozessor mit Substrat und Wärmeleitabdeckung festgelegt.

Das Positionierungsmittel umfasst mindestens eine Aussparung zur Positionierung des jeweiligen Mikroprozessors und/oder dessen Substrats. Dadurch wird erreicht, dass der Mikroprozessor und/oder dessen Substrat formschlüssig fixiert wird, wodurch das Risiko von Beschädigungen verringert wird. Insbesondere kann die Vorrichtung mindestens einen Adapter aufweisen, welcher lösbar im Positionierungsmittel fixiert werden kann, wobei der Adapter mindestens eine der mindestens einen Aussparung zur Positionierung des jeweiligen Mikroprozessors und/oder dessen Substrats umfasst. Dadurch kann die Aussparung gewechselt werden und an verschiedene Mikroprozessoren und/oder deren Substrate angepasst werden, was die Flexibilität der Vorrichtung erhöht.

Das Druckübertragungsmittel kann einen Schieber aufweisen, wodurch die Kraft auf einer breiten Fläche auf die Wärmeleitabdeckung wirken kann und somit der Druck niedriger gehalten werden kann, wodurch wieder das Risiko von Beschädigungen verringert wird.

Die Vorrichtung kann Antriebsmittel zum Antrieb des Druckübertragungsmittels aufweisen. Diese ermöglichen dem Nutzer, den Druck aufzubauen. Das Antriebsmittel eine Schraube umfasst, welche auf das Druckübertragungsmittel wirkt und die von einem Nutzer gedreht werden kann, um das Druckübertragungsmittel anzutreiben. Durch eine Schraube kann der Druck durch den Nutzer genau eingestellt werden, es können wenn nötig relativ hohe Drücke erzeugt werden und die Bewegung des Druckübertragungsmittels kann genau gesteuert werden, so dass das Druckübertragungsmittel nach dem Entfernen der Wärmeleitabdeckung nicht überschießt und möglicherweise zu Schäden am Mikroprozessor und/oder Substrat führt.

Die Vorrichtung kann mindestens ein Sichtfenster zur Überwachung des Entfernens der mindesten einen Wärmeleitabdeckung aufweisen, so dass das Aufbringen des Drucks eingestellt werden kann, wenn die Entfernung erfolgt ist, wodurch wieder das Risiko von Beschädigungen verringert wird.

Die Vorrichtung kann mindestens eine Aussparung zum Wiederverkleben einer Wärmeleitabdeckung mit dem Mikroprozessor beziehungsweise Substrat aufweisen. Dadurch wird der Mikroprozessor mit Substrat für das Kleben fixiert, so dass der Klebevorgang erleichtert und genauer wird.

Das Positionierungsmittel und das Druckübertragungsmittel der Vorrichtung können mindestens teilweise aus Polyoxymethylen bestehen.

Die Vorrichtung kann zum simultanen Entfernen von mindestens zwei Wärmeleitabdeckungen von jeweils einem Mikroprozessor mit Substrat und Wärmeleitabdeckung ausgelegt sein. Dazu ist das Positionierungsmittel zum Positionieren der mindestens zwei Mikroprozessoren mit Substrat ausgelegt und das Druckübertragungsmittel zur simultanen Übertragung eines Drucks auf die mindestens zwei Wärmeleitabdeckungen. Dies erhöht die Effizienz, da in der gleichen Zeit mindestens zwei Wärmeleitabdeckungen entfernt werden können.

Die Vorrichtung kann zur automatisierten Entfernung mindestens einer Wärmeleitabdeckung von jeweils einem Mikroprozessor mit Substrat und Wärmeleitabdeckung ausgelegt sein. Dazu weist sie zusätzlich auf:
- Einsetz- und Entnahmemittel zum automatisierten Einsetzen des mindestens einen Mikroprozessors mit Substrat und Wärmeleitabdeckung in die Vorrichtung und zum automatisierten Entnehmen des mindestens einen Mikroprozessors mit Substrat nach Entfernung der Wärmeleitabdeckung,
- Antriebsmittel zum automatisierten Antrieb der Druckübertragungsvorrichtung,
- insbesondere weiterhin
   ∘ Auswurfmittel zum automatisierten Auswurf der mindestens einen entfernten Wärmeleitabdeckung,
   ∘ Steuerungsmittel zur automatischen Steuerung der Einsetz- und Entnahmemittel, Antriebsmittel und Auswurfmittel, wobei die Steuerung Überwachungsmittel aufweisen kann, zum Beispiel eine Kamera, zur Überwachung des Einsetzens des mindestens einen Mikroprozessors mit Substrat und Wärmeleitabdeckung, Entnehmens des mindestens einen Mikroprozessors mit Substrat, Entfernens der mindestens einen Wärmeleitabdeckung und Auswurfs der mindestens einen Wärmeleitabdeckung.

Ein anderer Aspekt der Erfindung betrifft ein Verfahren zum Entfernen mindestens einer Wärmeleitabdeckung von jeweils einem Mikroprozessor, der ein Substrat und eine Wärmeleitabdeckung aufweist, wie in Anspruch 14 offenbart.

Die Wärmeleitabdeckung, auch "Heatspreader" genannt, kann eine integrierte Wärmeleitabdeckung des Mikroprozessors sein.

Eine Vorrichtung zum Entfernen eines Integrated Heatspreaders eines Mikroprozessors kann aus Deckel, Boden und Druckschieber bestehen, wobei Boden und Deckel den Mikroprozessor fixieren. Hierbei kann insbesondere der Deckel eine Aussparung für einen Druckschieber enthalten und der Boden zusätzlich eine Aussparung für den Mikroprozessor besitzen. Weiterhin kann insbesondere sich im Deckel eine zusätzliche Aussparung befinden. Weiterhin kann insbesondere der Druckschieber zwischen Boden und Deckel geführt werden. Außerdem kann ein Sichtfenster im Deckel vorhanden sein.

### Beschreibung der Ausführungsbeispiele

Im Folgenden werden die Figuren kurz beschrieben.
Figuren 1 bis 4 zeigen schematisch ein erstes Ausführungsbeispiel der Erfindung.
Figur 1 zeigt eine Vorrichtung zum Entfernen einer Wärmeleitabdeckung von einem Mikroprozessor, bei der die beiden Bauelemente der Positionierungsmittel zusammengesetzt sind.
Figur 2 zeigt eins der Bauelemente der Positionierungsmittel und dazu einen Schieber.
Figur 3 zeigt ein anderes Bauelement der Positionierungsmittel.
Figur 4 zeigt einen Querschnitt durch das Bauelement aus Figur 3 entlang der schraffierten Linie in Figur 3.
Figuren 5 und 6 zeigen eine Variante des ersten Ausführungsbeispiels.
Figuren 7 bis 9 zeigen eine zweite Ausführungsform der Erfindung.
Figur 10 zeigt eine Variante der zweiten Ausführungsform
Figur 11 zeigt eine dritte Ausführungsform der Erfindung, wobei das Entfernen automatisch erfolgt.
Figur 12 zeige ein viertes Ausführungsbeispiel, wobei mindestens zwei Wärmeleitabdeckungen simultan entfernt werden können.
Figur 13 zeigt eine Variante des vierten Ausführungsbeispiels.

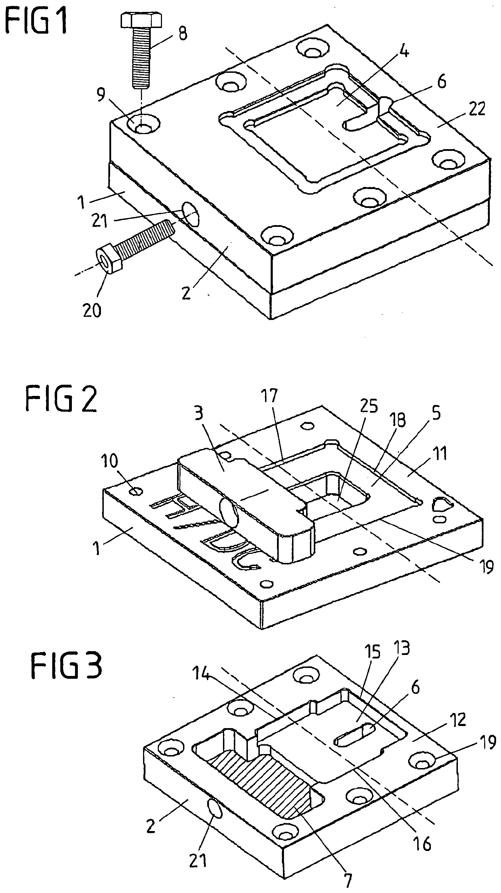

Ein erstes Ausführungsbeispiel wird in Figuren 1 bis 4 beschrieben. Die Positionierungsmittel umfassen zwei Bauelemente 1, 2, welche lösbar verbunden werden können, zum Beispiel mittels Schrauben 8. Jedes Bauelement 1, 2 umfasst hier sechs Bohrungen 9 beziehungsweise 10 für Schrauben 8, wobei die genaue Anzahl nicht wesentlich ist. Das erste Bauelement 1 weist eine Oberfläche 11 auf, die beim Verbinden mit dem zweiten Bauelement 2 gegenüber der Oberfläche 12 des zweiten Bauelements 2 liegt, zum Beispiel können sich diese berühren.

Das erste Bauelement 1 weist in der Oberfläche 11 eine Aussparung 5 auf, in die ein Mikroprozessor mit Substrat (in den Figuren nicht dargestellt) so gelegt wird, dass die mit dem Mikroprozessor verklebte Wärmeleitabdeckung in Richtung des zweiten Bauelements 2 zeigt, wenn die Bauelemente 1, 2 verbunden sind. Die Tiefe der Aussparung 5 relativ zur Oberfläche 11 ist dabei so gewählt, dass sie im Wesentlichen der Dicke des Substrats entspricht. Innerhalb der Aussparung 5 kann eine weitere Aussparung 25 vorhanden sein, um von der dem Mikroprozessor gegenüberliegenden Seite des Substrats vorstehende Bauelemente aufzunehmen. Die Abmessung und Geometrie der Aussparung 5, das heißt ihre Länge und Breite, sind der Form und den Abmessungen des Substrats angepasst, so dass das Substrat formschlüssig in der Aussparung lösbar fixiert wird.

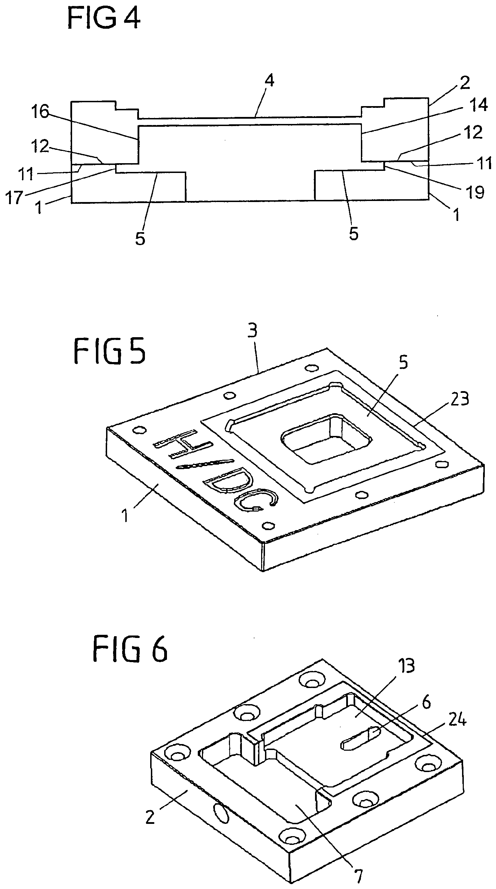

Das zweite Bauelement 2 weist in der Oberfläche 12 eine Aussparung 13 und eine damit verbundene Aussparung 7 auf. Aussparung 7 ist in Figur 3 schraffiert dargestellt. Wenn Bauelemente 1, 2 so miteinander verbunden werden, dass Oberfläche 11 gegenüber der Oberfläche 12 liegt, zum Beispiel dass sich diese berühren, wird das Substrat des Mikroprozessors in der Aussparung 5 abgesehen von einem gewissen Spiel vollständig formschlüssig fixiert, da die Ränder 14 und 16 der Aussparung 13 das Substrat in der Aussparung 5 halten, da sie über die Ränder 19 und 17 der Aussparung 5 herausragen, wie in Figur 4 ersichtlich. Die Abmessungen der Aussparung 13, d. h. ihre Tiefe relativ zur Oberfläche 12, ihre Länge und Breite und ihre Form, sind so bemessen, dass der Mikroprozessor mit Wärmeleitabdeckung in diese vollständig hereinpasst. Dazu ist in Richtung Rand 15 noch Spielraum, so dass sich eine vom Mikroprozessor und Substrat entfernende oder ablösende Wärmeleitabdeckung so weit in Richtung Rand 15 bewegen kann, bis sie nicht mehr am Mikroprozessor und Substrat klebt.

In der Aussparung 7 befindet sich der Schieber 3 als Druckaufbringungsmittel. Wenn die Bauelemente 1, 2 so miteinander verbunden werden, dass Oberfläche 11 gegenüber der Oberfläche 12 liegt, zum Beispiel dass sich diese berühren, wird der Schieber abgesehen von einem gewissen Spiel formschlüssig in der Aussparung 7 durch den Boden und die Ränder der Aussparung 7 und die Oberfläche 11 gehalten, lediglich parallel zu den Oberflächen 11, 12 in Richtung des in Figur 2 gezeigten Pfeils und entgegengesetzt dazu ist eine Bewegung möglich. Bewegt sich der Schieber 3 in Richtung des Mikroprozessors mit Wärmeleitabdeckung, so kann, wenn genügend Druck durch den Schieber 3 auf die Wärmeleitabdeckung aufgebaut wird, die Wärmeleitabdeckung vom Mikroprozessor und Substrat entfernt werden. Die Aussparung 7 reicht dabei in Richtung Aussparung 13 so weit, dass der Schieber 3 die Wärmeleitabdeckung so weit schieben kann, dass sie sich vom Mikroprozessor und Substrat löst. Der Schieber 3 kann mittels eines Antriebsmittels in Form einer Schraube 20, welche durch eine Bohrung 21, die ein zur Schraube 20 korrespondierendes Gewinde aufweisen kann, in Pfeilrichtung und entgegengesetzt dazu bewegt werden.

Das zweite Bauelement 2 kann ein Sichtfenster 6 aufweisen, welches durchgeht von der Aussparung 13 bis zur Oberfläche 22, welche der Oberfläche 12 gegenüber liegt. Damit ist der Fortschritt des Entfernens von außen beobachtbar, das heißt, ob sich die Wärmeleitabdeckung bewegt beziehungsweise ob sie entfernt wurde. Dieses Sichtfenster 13 befindet sich insbesondere nahe zum Rand 15, so dass eine sich bewegende Kante der Wärmeleitabdeckung wahrnehmbar ist.

Das zweite Bauelement 2 kann eine Aussparung 4 aufweisen, die in ihrer Geometrie im Wesentlichen der Form des Substrats entspricht, um dieses formschlüssig fixieren zu können, um nach erfolgter Entfernung der Wärmeleitabdeckung wieder leichter eine solche zu verkleben.

Eine Variante des ersten Ausführungsbeispiels wie in Figuren 5 und 6 gezeigt kann Adapter 23 und 24 umfassen, welche jeweils im ersten Bauelement 1 beziehungsweise zweiten Bauelement 2 lösbar befestigt werden können. Dazu weisen die Bauelemente 1, 2 Aussparungen oder Fenster auf, in welchen die Adapter 23 beziehungsweise 24 fixiert werden können. Der Adapter 23 des Bauelements 1 ist so positioniert, dass die komplette Aussparung 5 in diesem Adapter 23 liegt. Entsprechend ist der Adapter 24 des Bauelements 2 so gestaltet, dass er die komplette Aussparung 13 umfasst. Ein solcher Adapter 23 beziehungsweise 24 ermöglicht es, die Aussparungen 5 und 13 zu verändern und an unterschiedliche Geometrien der Mikroprozessoren, Substrate und Wärmeleitabdeckungen anzupassen. Beispielsweise kann zu einem ersten Bauelement 1 ein Satz von Adaptern 23 gehören, die jeweils unterschiedliche Aussparungen 5 umfassen, welche an verschiedene Substratabmessungen angepasst sind. Entsprechend kann zu jedem zweiten Bauelement 2 ein Satz von Adaptern 24 gehören, die jeweils unterschiedliche Aussparungen 13 umfassen, welche an verschiedene Mikroprozessor- und Wärmeleitabdeckungsabmessungen angepasst sind. Die Adapter 23, 24 können mit Schrauben in der dafür vorgesehenen Aussparung beziehungsweise im dafür vorgesehenen Fenster des Bauelements 1, 2 befestigt werden.

Die weiteren Merkmale des Ausführungsbeispiels bleiben unverändert.

Sowohl das erste Ausführungsbeispiel als auch seine Variante umfassen neben der Vorrichtung zum Entfernen einer Wärmeleitabdeckung auch ein Verfahren zum Entfernen einer Wärmeleitabdeckung von einem Mikroprozessor mit Substrat unter Verwendung der Vorrichtung. Dieses Verfahren umfasst als ersten Schritt das Einlegen eines Mikroprozessors mit Substrat und Wärmeleitabdeckung in die Aussparung 5. Als nächstes wird das zweite Bauelement 2 so auf dem Bauelement 1 platziert, dass sich der Mikroprozessor in Aussparung 13 befindet und dann mittels der Schrauben 8 an Bauelement 1 fixiert. Der Schieber 3 muss sich dabei in Aussparung 7 befinden. Durch Drehen der Schraube 20 wird Schieber 3 in Richtung Wärmeleitabdeckung bewegt, bis diese entfernt ist. Das erfolgreiche Entfernen wird durch das Sichtfenster 6 kontrolliert. Anschließend wird das zweite Bauelement 2 wieder vom ersten Bauelement 1 entfernt und die Wärmeleitabdeckung getrennt vom Mikroprozessor mit Substrat entnommen.

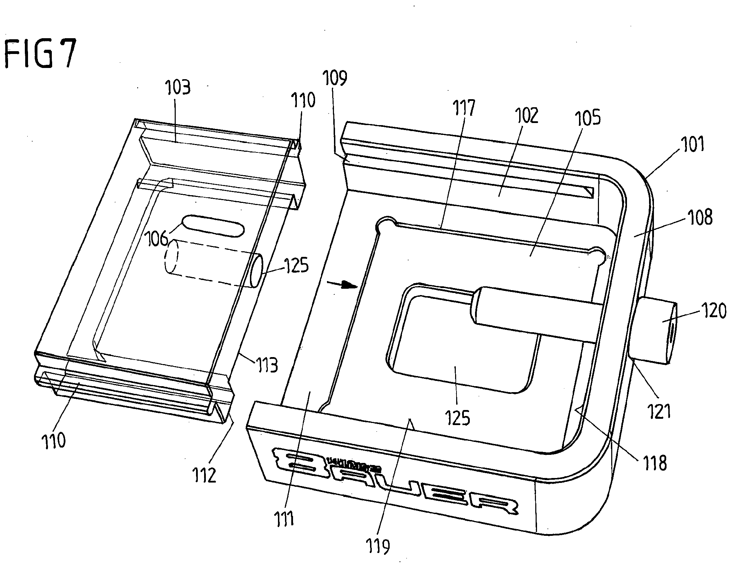

Ein zweites Ausführungsbeispiel ist in den Figuren 7 bis 10 offenbart. Dieses Ausführungsbeispiel weist Positionierungsmittel in Form eines Bauelements 101 auf. Dieses Bauelement 101 weist eine Aussparung 102 in einer Oberfläche 108 auf. Das erste Bauelement 101 weist am Boden der Aussparung 102 Oberfläche 111 auf. In der Oberfläche 111 ist wiederum eine Aussparung 105 angeordnet ist.

Diese Aussparung 105 entspricht in ihrer Funktion der Aussparung 5 des ersten Ausführungsbeispiels. In der Aussparung 105 wird der Mikroprozessor mit Substrat (in den Figuren nicht dargestellt) so gelegt, dass die mit dem Mikroprozessor verklebte Wärmeleitabdeckung in Richtung der Oberfläche 108 des Bauelements 101 zeigt. Die Tiefe der Aussparung 105 relativ zur Oberfläche 111 ist dabei so gewählt, dass sie im Wesentlichen der Dicke des Substrats entspricht. Innerhalb der Aussparung 105 kann eine weitere Aussparung 125 vorhanden sein, um von der dem Mikroprozessor gegenüberliegenden Seite des Substrats vorstehende Bauelemente aufzunehmen. Die Abmessungen und Geometrie der Aussparung 105, das heißt ihre Länge und Breite, sind der Form und den Abmessungen des Substrats angepasst, so dass das Substrat formschlüssig in der Aussparung lösbar fixiert wird.

Bauelement 103 wird in der Aussparung 102 gleitend geführt durch zueinander korrespondierende Führungsmittel 109 und 110, welche an den Bauelementen 101 und 103 vorgesehen sind. Im vorliegenden Beispiel ist das Führungsmittel 109 eine Nut und das Führungsmittel 110 eine Feder. Durch die Führung kann sich Bauelement 103 nur parallel in und entgegen der Pfeilrichtung wie in Figur 7 dargestellt bewegt werden, d.h. entlang einer Richtung parallel zur Oberfläche 111. Dabei kann die Aussparung 102 so gestaltet sein, dass Bauelement 103 ganz aus der Führung 109 am Bauelement 101 entfernt werden kann, wie in Figur 7 dargestellt.

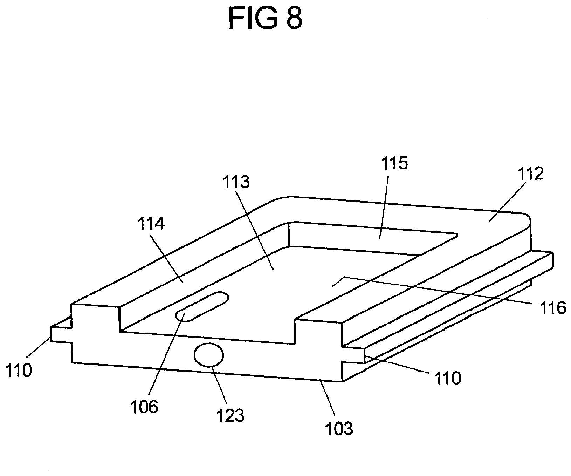

Bauelement 103 weist in der Oberfläche 112 eine Aussparung 113 auf. Wenn Bauelemente 103 so in Bauelement 101 geführt ist, dass Oberfläche 111 gegenüber der Oberfläche 112 liegt, zum Beispiel dass sich diese berühren, wird das Substrat des Mikroprozessors in der Aussparung 105 abgesehen von einem gewissen Spiel vollständig formschlüssig fixiert, da die Ränder 114 und 116 der Aussparung 113 das Substrat in der Aussparung 105 halten, da sie über die Ränder 119 und 117 der Aussparung 5 herausragen, analog zum ersten Ausführungsbeispiel. Die Tiefe der Aussparung 113 relativ zur Oberfläche 112 und ihre Breite zwischen Rändern 114 und 116 und ihre Form sind so bemessen, dass der Mikroprozessor mit Wärmeleitabdeckung in diese hereinpasst. Das heißt, die Höhe des Mikroprozessors mit Wärmeleitabdeckung ist geringer oder gleich der Tiefe der Aussparung und die Breite des Mikroprozessors inklusive Wärmeleitabdeckung ist geringer oder gleich der Breite der Aussparung. Die Aussparung 113 weist eine offene Seite auf, in Figur 8 gegenüber Rand 115. Über diese offene Seite kann Bauelement 103 über den Mikroprozessor mit Wärmeleitabdeckung geschoben werden.

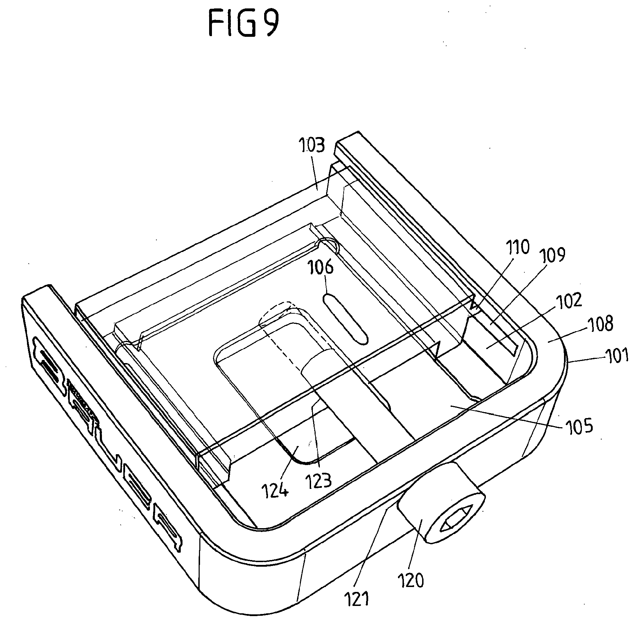

Bauelement 103 fungiert als Druckaufbringungsmittel, d.h. als Schieber, wenn Bauelemente 103 und 101 wie oben beschrieben so gleitend miteinander verbunden werden, dass Oberfläche 111 gegenüber der Oberfläche 112 liegt, zum Beispiel dass sich diese berühren Bewegt sich der Bauelement 103 in Richtung des Mikroprozessors mit Wärmeleitabdeckung, so kann, wenn genügend Druck durch das Bauelement 103 auf die Wärmeleitabdeckung aufgebaut wird, die Wärmeleitabdeckung vom Mikroprozessor und Substrat entfernt werden. Die Länge der Aussparung 113, das heißt ihre Ausdehnung in Pfeilrichtung, ist dabei so begrenzt, dass das Bauelement 103 so weit im Bauelement 101 gleiten kann, dass der Rand 115 die Wärmeleitabdeckung so weit schieben kann, dass sie sich vom Mikroprozessor und Substrat löst. Das Bauelement 103 kann mittels eines Antriebsmittels in Form einer Schraube 120, welche durch eine Bohrung 121 ohne Gewinde reicht, in Pfeilrichtung und entgegengesetzt dazu bewegt werden, in dem die Schraube 120 in ein zum Außengewinde der Schraube 120 korrespondierendes Innengewinde in einer Bohrung 125 auf Bauelement 103 eingreift, wie in Figur 9 gezeigt.

Bauelement 103 kann ein Sichtfenster 106 aufweisen, welches durchgeht vom Boden der Aussparung 113 bis zur gegenüber liegenden Oberfläche des Bauelements 103, wie in Figur 7 ersichtlich. Damit ist der Fortschritt des Entfernens von außen beobachtbar, das heißt ob sich die Wärmeleitabdeckung bewegt beziehungsweise ob sie entfernt wurde. Dieses Sichtfenster 13 befindet sich insbesondere nahe zum Rand des Bauelements 103, der die Bohrung 125 aufweist, so dass eine sich bewegende Kante der Wärmeleitabdeckung wahrnehmbar ist. Abhängig von den Dimensionen der Wärmeleitabdeckung und ihre Lage auf dem Substrat ist der Fortschritt auch durch den Spalt zwischen Rand 118 der Aussparung 102 und dem Rand des Bauelements 103, der die Bohrung 125 aufweist, zu beobachten.

Analog zum ersten Ausführungsbeispiel kann Bauelement 101 eine weitere, Aussparung 4 entsprechende Aussparung aufweisen, die in ihrer Geometrie im Wesentlichen der Form des Substrats entspricht, um dieses formschlüssig fixieren zu können, um nach erfolgter Entfernung der Wärmeleitabdeckung wieder leichter eine solche zu verkleben.

Eine Variante des zweiten Ausführungsbeispiels kann einen Adapter 123 aufweisen, welcher im Bauelement 101 lösbar befestigt werden kann. Dazu weist Bauelement 101 eine Aussparungen oder Fenster auf, in welcher der Adapter 123 fixiert werden kann. Der Adapter 123 des Bauelements 101 ist so positioniert, dass die komplette Aussparung 105 in diesem Adapter 123 liegt. Ein solcher Adapter 23 ermöglicht es, die Aussparungen 105 zu verändern und an unterschiedliche Geometrien der Mikroprozessoren, Substrate und Wärmeleitabdeckungen anzupassen. Beispielsweise kann zu einem Bauelement 101 ein Satz von Adaptern 123 gehören, die jeweils unterschiedliche Aussparungen 105 umfassen, welche an verschiedene Substratabmessungen angepasst sind. Der Adapter 123 kann mit Schrauben in der dafür vorgesehenen Aussparung beziehungsweise im dafür vorgesehenen Fenster des Bauelements 101 befestigt werden. Dazu kann zusätzlich ein Satz von Bauelementen 103 mit an die Aussparungen 105 der Adapter 123 angepassten Formgebungen bereitgestellt werden, sollte ein universelles Bauelement 103 nicht für alle Mikroprozessoren geeignet sein.

Die weiteren Merkmale des Ausführungsbeispiels bleiben unverändert.

Sowohl das zweite Ausführungsbeispiel als auch seine Variante umfassen neben der Vorrichtung zum Entfernen einer Wärmeleitabdeckung auch ein Verfahren zum Entfernen einer Wärmeleitabdeckung von einem Mikroprozessor mit Substrat unter Verwendung der Vorrichtung. Dieses Verfahren umfasst als ersten Schritt das Einlegen eines Mikroprozessors mit Substrat und Wärmeleitabdeckung in die Aussparung 105. Als nächstes wird Bauelement 103 in die Nut 109 in Bauelement 101 eingesetzt. Durch Drehen der Schraube 120 wird Bauelement 103 in Richtung Wärmeleitabdeckung bewegt, bis diese entfernt ist. Das erfolgreiche Entfernen wird durch das Sichtfenster 106 kontrolliert. Anschließend wird Bauelement 103 wieder von Bauelement 101 entfernt und die Wärmeleitabdeckung getrennt vom Mikroprozessor mit Substrat entnommen.

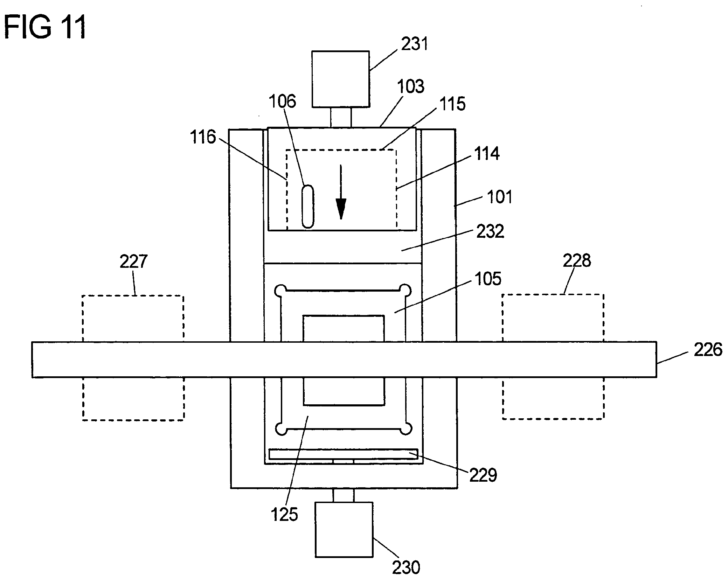

Beide Ausführungsbeispiele können in einer Variante automatisiert werden, wie als drittes Ausführungsbeispiel in Figur 11 anhand einer Variante des zweiten Ausführungsbeispiels schematisch gezeigt. Das Prinzip der Entfernung der Wärmeleitabdeckung entspricht dem des zweiten Ausführungsbeispiels, deshalb wird es hier nicht wiederholt. Referenzzeichen in diesem Ausführungsbeispiel, die sich auch im zweiten Ausführungsbeispiel wiederfinden, bezeichnen Bauelemente, die dem zweiten Ausführungsbeispiel entsprechen.

Zur Automatisierung umfasst die Vorrichtung eine automatische Einsetz- und Entnahmevorrichtung 226, welche Mikroprozessoren mit Substrat und Wärmeleitabdeckung von einem Stapel 227 einzeln entnimmt und diese in die Aussparung 105 einsetzt. Nach erfolgter Entfernung der Wärmeleitabdeckung werden die Mikroprozessoren mit Substrat von der Einsetz- und Entnahmevorrichtung 226 wieder aus der Aussparung entnommen und auf einen anderen Stapel 228 abgelegt. Das Bauelement 101 ist in dieser Variante verlängert, so dass Bauelement 103 so weit in Nut 109 geführt verschiebbar ist, dass es die Aussparung 105 nicht mehr überdeckt und ein Spalt 232 frei beibt, dessen Funktion später erläutert wird.

Im Unterschied zum zweiten Ausführungsbeispiel erfolgt der Antrieb des Bauelements 103 nicht mehr mittels einer Schraube, welche durch eine Bohrung in Bauelement 101 verläuft. Der Antrieb ist stattdessen so gestaltet, dass er die Aussparung 105 nicht überdeckt. Bauelement 103 wird von der Seite angetrieben, die bei dem in Pfeilrichtung erfolgenden Entfernungsvorgang rückseitig liegt. Ein dafür vorgesehener Antrieb kann zum Beispiel pneumatisch, hydraulisch oder durch einen Stellmotor 231 erfolgen. Entfernte Wärmeleitabdeckungen werden durch eine Auswurfvorrichtung in Form eines Schiebers 229 durch den Spalt 232 ausgeworfen. Der Antrieb kann zum Beispiel pneumatisch, hydraulisch oder durch einen Stellmotor 230 erfolgen. Eine auf die Aussparung 105 gerichtete Kamera überwacht das korrekte Einsetzen des Mikroprozessors mit Substrat und Wärmeleitabdeckung in Aussparung 105, das Entfernen der Wärmeleitabdeckung und ihren Auswurf.

Die Vorrichtung gemäß drittem Ausführungsbeispiel umfasst weiterhin eine Steuereinrichtung, welche die automatische Einsetz- und Entnahmevorrichtung 226, und die beiden Antriebe 230 und 231 steuert. Die Kamera ist ebenfalls an die Steuerung angeschlossen. In der Steuerung wird das Bild mittels Bildverarbeitung ausgewertet um so eine erfolgreiche Entfernung der Wärmeleitabdeckung, einen erfolgreichen Auswurf der Wärmeleitabdeckung und das korrekte Einsetzen des Mikroprozessors mit Substrat und Wärmeleitabdeckung in Aussparung 105 festzustellen.

Als ersten Schritt steuert die Steuereinrichtung die Einsetz- und Entnahmevorrichtung 226, einen Mikroprozessor mit Substrat und Wärmeleitabdeckung von Stapel 227 zu entnehmen und in die Aussparung 105 einzusetzen. Nach Erkennen des korrekten Einsetzens mittels automatischer Bildauswertung des Kamerabilds wird der Entfernungsvorgang durch das Aktivieren des Antriebs 231 durch die Steuerung eingeleitet. Nach Kontrolle des korrekten Entfernens der Wärmeleitabdeckung mittels automatischer Bildauswertung des Kamerabilds wird der Auswurfvorgang durch das Aktivieren des Antriebs 230 durch die Steuerung eingeleitet. Nach Kontrolle des korrekten Auswurfs der Wärmeleitabdeckung mittels automatischer Bildauswertung des Kamerabilds steuert die Steuereinrichtung die Einsetz- und Entnahmevorrichtung 226, den Mikroprozessor mit Substrat aus der Aussparung 105 zu entnehmen und ihn auf dem Stapel 228 abzusetzen und wieder einen Mikroprozessors mit Substrat und Wärmeleitabdeckung von Stapel 227 zu entnehmen.

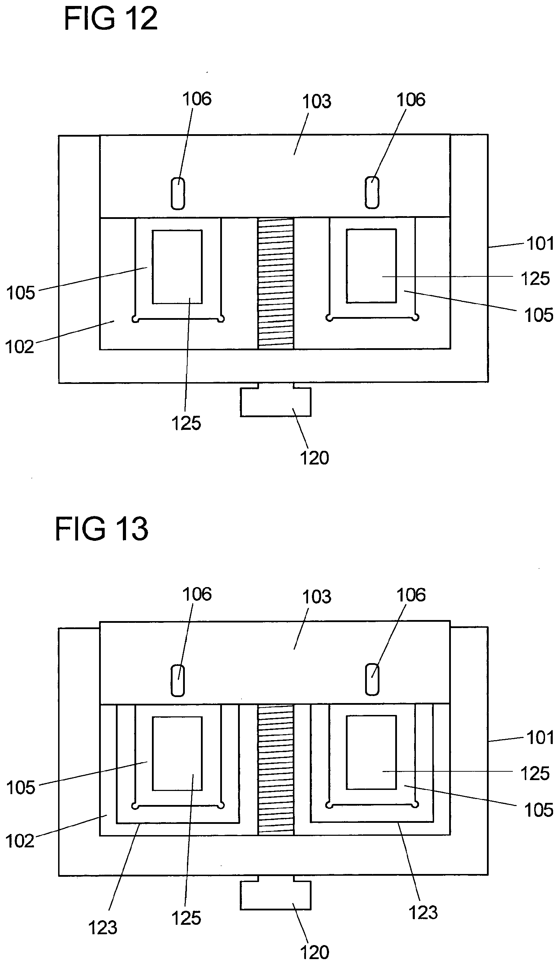

Alle obigen Ausführungsbeispiele können das parallele Entfernen der Wärmeleitabdeckungen von mehreren Mikroprozessoren mit Substrat mit Substrat ermöglichen. Figur 12 zeigt ein viertes Ausführungsbeispiel als Variante des zweiten Ausführungsbeispiels. Das Prinzip der Entfernung der Wärmeleitabdeckung entspricht dem des zweiten Ausführungsbeispiels, deshalb wird es hier nicht wiederholt. Referenzzeichen in diesem Ausführungsbeispiel, die sich auch im zweiten Ausführungsbeispiel wiederfinden, bezeichnen Bauelemente, die dem zweiten Ausführungsbeispiel entsprechen. Im Unterschied zum zweiten Ausführungsbeispiel befinden sich in der Aussparung 102 des Bauelements 101 mehrere Aussparungen 105, jeweils mit Aussparung 125, in die jeweils ein Mikroprozessor mit Substrat und Wärmeleitabdeckung platziert werden kann. Durch Verschieben des Bauelements 103 mittels Schraube 120 werden zeitgleich beide Wärmeleitabdeckungen entfernt. Zur Kontrolle sind zwei Sichtfenster 106 vorgesehen.

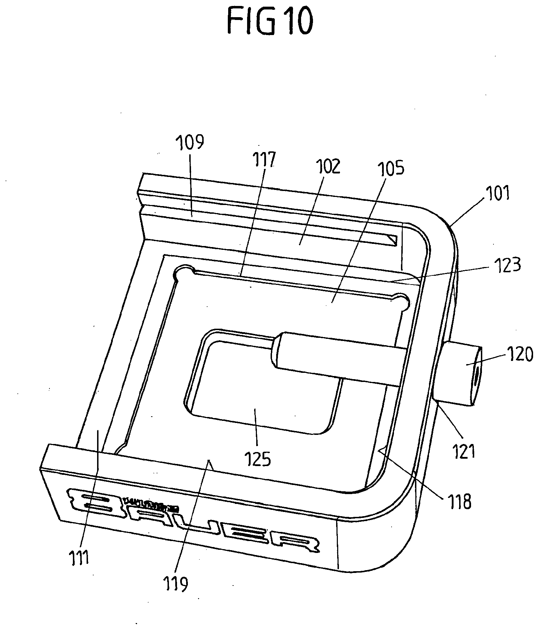

Figur 13 zeigt eine Variante des vierten Ausführungsbeispiels, bei dem analog zur in Figur 10 gezeigten Variante des zweiten Ausführungsbeispiels die Aussparungen 105 jeweils in Adaptern 123 angeordnet sind. Adapter 123 können in Bauelement 101 lösbar befestigt werden. Dazu weist Bauelement 101 Aussparungen oder Fenster auf, in welchen die Adapter 123 fixiert werden können. Die Adapter 123 des Bauelements 101 sind so positioniert, dass die komplette Aussparung 105 im jeweiligen Adapter 123 liegt. Solche Adapter 123 ermöglichen es, die Aussparungen 105 zu verändern und an unterschiedliche Geometrien der Mikroprozessoren, Substrate und Wärmeleitabdeckungen anzupassen. Beispielsweise kann zu einem Bauelement 101 ein Satz von Adaptern 123 gehören, die jeweils unterschiedliche Aussparungen 105 umfassen, welche an verschiedene Substratabmessungen angepasst sind. Die Adapter 123 können mit Schrauben in dafür vorgesehenen Aussparungen beziehungsweise in dafür vorgesehenen Fenstern des Bauelements 101 befestigt werden. Dazu kann zusätzlich ein Satz von Bauelementen 103 mit an die Aussparungen 105 der Adapter 123 angepassten Formgebungen bereitgestellt werden, sollte ein universelles Bauelement 103 nicht für alle Mikroprozessoren geeignet sein.

Sowohl das vierte Ausführungsbeispiel als auch seine Variante umfassen neben der Vorrichtung zum Entfernen von Wärmeleitabdeckungen auch ein Verfahren zum Entfernen von Wärmeleitabdeckung von Mikroprozessoren mit Substrat unter Verwendung der Vorrichtung. Dieses Verfahren umfasst als ersten Schritt das Einlegen von Mikroprozessoren mit Substrat und Wärmeleitabdeckung in die Aussparungen 105. Als nächstes wird Bauelement 103 in die Nut 109 in Bauelement 101 eingesetzt. Durch Drehen der Schraube 120 wird Bauelement 103 in Richtung der Wärmeleitabdeckungen bewegt, bis diese entfernt sind. Das erfolgreiche Entfernen wird durch die Sichtfenster 106 kontrolliert. Anschließend wird Bauelement 103 wieder von Bauelement 101 entfernt und die Wärmeleitabdeckungen getrennt von den Mikroprozessoren mit Substrat entnommen.

Die obigen Ausführungsbeispiele beziehen sich auf eine Vorrichtung und ein Verfahren zum Entfernen einer Wärmeleitabdeckung von einem Mikroprozessor. Die ist jedoch nicht auf eine solche Anwendung begrenzt. Stattdessen bezieht die Erfindung sich allgemein auf das Entfernen oder Ablösen von Komponenten von anderen Komponenten, mit denen erstere verklebt sind. Eine weitere mögliche Anwendung wäre das Entfernen von Schutzkomponenten, die auf touch screens geklebt werden.

Die Ausführungsbeispiele zeigen lediglich bevorzugt Ausführungsformen der Erfindung. Die Erfindung selbst wird alleine durch den Wortlaut der Ansprüche begrenzt.

## Patentansprüche

1. Vorrichtung zum Entfernen mindestens einer Wärmeleitabdeckung von jeweils einem Mikroprozessor, der ein Substrat und eine Wärmeleitabdeckung aufweist, umfassend
- ein Positionierungsmittel zum Positionieren des mindestens einen Mikroprozessors, wobei das Positionierungsmittel mindestens eine Aussparung (5, 13; 105) zur Positionierung des jeweiligen Mikroprozessors und/oder dessen Substrats umfasst, durch die der Mikroprozessor und/oder dessen Substrat formschlüssig fixierbar ist,
- ein Druckübertragungsmittel zur Übertragung eines Drucks auf die mindestens eine Wärmeleitabdeckung zum Entfernen der mindestens einen Wärmeleitabdeckung und
- eine Führung zum Führen des Druckübertragungsmittels, wobei
a) das Positionierungsmittel ein Bauelement (101) aufweist und der mindestens eine Mikroprozessor zwischen dem Bauelement (101) und dem Druckübertragungsmittel lösbar fixiert ist,
oder
b) das Positionierungsmittel mindestens zwei lösbar miteinander verbindbare Bauelemente (1, 2) umfasst und der mindestens eine Mikroprozessor zwischen den Bauelementen (1, 2) fixierbar ist, wenn die Bauelemente (1, 2) miteinander verbunden sind.

2. Vorrichtung gemäß Anspruch 1, **dadurch gekennzeichnet, dass** der Druck in einer Richtung aufgebracht werden kann, die im Wesentlichen parallel zur Oberfläche des Substrats des mindestens einen Mikroprozessors verläuft.

3. Vorrichtung gemäß Anspruch 1 oder 2, **dadurch gekennzeichnet, dass** das Positionierungsmittel die Führung aufweist.

4. Vorrichtung nach einem der vorhergehenden Ansprüche, **dadurch gekennzeichnet, dass** die Führung ausgelegt ist, das Druckübertragungsmittel in einer Richtung im Wesentlichen parallel zur Oberfläche des Substrats des mindestens einen Mikroprozessors zu führen.

5. Vorrichtung nach einem der vorhergehenden Ansprüche, **gekennzeichnet durch** mindestens einen Adapter (23, 24; 123), welcher lösbar im Positionierungsmittel fixiert werden kann, wobei der Adapter (23, 24; 123) mindestens eine der mindestens einen Aussparung (5, 13; 105) zur Positionierung des jeweiligen Mikroprozessors und/oder dessen Substrats umfasst.

6. Vorrichtung nach einem der vorhergehenden Ansprüche, **dadurch gekennzeichnet, dass** das Druckübertragungsmittel einen Schieber (3) aufweist.

7. Vorrichtung nach einem der vorhergehenden Ansprüche, **gekennzeichnet durch** Antriebsmittel zum Antrieb des Druckübertragungsmittels.

8. Vorrichtung nach Anspruch 7, **dadurch gekennzeichnet, dass** das Antriebsmittel eine Schraube (20; 120) umfasst, welche auf das Druckübertragungsmittel wirkt und die von einem Nutzer gedreht werden kann, um das Druckübertragungsmittel anzutreiben.

9. Vorrichtung nach Anspruch 3, **dadurch gekennzeichnet, dass** die Bauelemente (1, 2) ausgelegt sind, das Druckübertragungsmittel zwischen beiden Bauelementen (1, 2) zu führen, wobei das Druckübertragungsmittel sich insbesondere in einer Aussparung (7) in einem der Bauelemente (2) befindet, wenn die Vorrichtung zusammengesetzt ist.

10. Vorrichtung nach einem der vorhergehenden Ansprüche, **gekennzeichnet durch** mindestens ein Sichtfenster (6; 106) zur Überwachung des Entfernens der mindestens einen Wärmeleitabdeckung.

11. Vorrichtung nach einem der vorhergehenden Ansprüche, **dadurch gekennzeichnet, dass** das Positionierungsmittel und das Druckübertragungsmittel mindestens teilweise aus Polyoxymethylen bestehen.

12. Vorrichtung nach einem der vorhergehenden Ansprüche zum simultanen Entfernen von mindestens zwei Wärmeleitabdeckungen von jeweils einem Mikroprozessor, **gekennzeichnet dadurch, dass**
- das Positionierungsmittel zum Positionieren der mindestens zwei Mikroprozessoren mit Substrat ausgelegt ist, und
- das Druckübertragungsmittel zur simultanen Übertragung eines Drucks auf die mindestens zwei Wärmeleitabdeckungen ausgelegt ist.

13. Vorrichtung nach einem der vorhergehenden Ansprüche zur automatisierten Entfernung mindestens einer Wärmeleitabdeckung von jeweils einem Mikroprozessor mit Substrat und Wärmeleitabdeckung, **gekennzeichnet durch**
- Einsetz- und Entnahmemittel zum automatisierten Einsetzen des mindestens einen Mikroprozessors mit Substrat und Wärmeleitabdeckung in das Positionierungsmittel und zum automatisierten Entnehmen des mindestens einen Mikroprozessors mit Substrat nach Entfernung der Wärmeleitabdeckung,
- Antriebsmittel zum automatisierten Antrieb der Druckübertragungsvorrichtung,
- insbesondere weiterhin umfassend
∘ Auswurfmittel zum automatisierten Auswurf der mindestens einen entfernten Wärmeleitabdeckung
∘ Steuerungsmittel zur automatischen Steuerung der Einsetz- und Entnahmemittel, Antriebsmittel und Auswurfmittel, wobei die Steuerung Überwachungsmittel aufweisen kann, zum Beispiel eine Kamera, zur Überwachung des Einsetzens des mindestens einen Mikroprozessors mit Substrat und Wärmeleitabdeckung, Entnehmens des mindestens einen Mikroprozessors mit Substrat, Entfernens der mindestens einen Wärmeleitabdeckung und Auswurfs der mindestens einen Wärmeleitabdeckung.

14. Verfahren zum Entfernen mindestens einer Wärmeleitabdeckung von jeweils einem Mikroprozessor, der ein Substrat und eine Wärmeleitabdeckung aufweist, unter Verwendung einer Vorrichtung nach einem der vorstehenden Ansprüche, umfassend die folgenden Schritte:
- Positionieren des mindestens einen Mikroprozessors in einem Positionierungsmittel, indem der Mikroprozessor und/oder dessen Substrat formschlüssig durch mindestens eine Aussparung (5, 13; 105) des Positionierungsmittels fixiert wird,
- Übertragen eines Drucks auf die mindestens eine Wärmeleitabdeckung, mittels eines Druckübertragungsmittels und dadurch Entfernen der mindestens einen Wärmeleitabdeckung,
- wobei der Druck, mittels einer Führung zum Führen des Druckübertragungsmittels geführt übertragen wird, wobei
a) das Positionierungsmittel ein Bauelement (101) aufweist, wobei der mindestens eine Mikroprozessor zwischen dem Bauelement (101) und dem Druckübertragungsmittel lösbar fixiert ist, oder
b) das Positionierungsmittel mindestens zwei lösbar miteinander verbindbare Bauelemente (1, 2) umfasst und der mindestens eine Mikroprozessor zwischen den Bauelementen (1, 2) fixierbar ist, wenn die Bauelemente (1, 2) miteinander verbunden sind, und
wobei die Schritte automatisiert durchgeführt werden können.

## Claims

1. Device for removing at least one heatspreader from a respective microprocessor which has a substrate and a heatspreader, comprising
- a positioning means for positioning the at least one microprocessor, wherein the positioning means comprises at least one recess (5, 13; 105) for positioning the respective microprocessor and/or its substrate, by means of which recess the microprocessor and/or its substrate is able to be fixed in a form-fitting manner,
- a pressure transfer means for transferring a pressure onto the at least one heatspreader for removing the at least one heatspreader, and
- a guide for guiding the heat transfer means, wherein
a) the positioning means has a structural element (101), and the at least one microprocessor is releasably fixed between the structural element (101) and the pressure transfer means,
or
b) the positioning means comprises at least two releasably interconnectable structural elements (1, 2), and the at least one microprocessor is able to be fixed between the structural elements (1, 2) when the structural elements (1, 2) are interconnected.

2. Device according to Claim 1, **characterized in that** the pressure can be applied in a direction which runs substantially parallel to the surface of the substrate of the at least one microprocessor.

3. Device according to Claim 1 or 2, **characterized in that** the positioning means has the guide.

4. Device according to one of the preceding claims, **characterized in that** the guide is designed to guide the pressure transfer means in a direction substantially parallel to the surface of the substrate of the at least one microprocessor.

5. Device according to one of the preceding claims, **characterized by** at least one adapter (23, 24; 123) which can be releasably fixed in the positioning means, wherein the adapter (23, 24; 123) comprises at least one of the at least one recess (5, 13; 105) for positioning the respective microprocessor and/or its substrate.

6. Device according to one of the preceding claims, **characterized in that** the pressure transfer means has a slide (3).

7. Device according to one of the preceding claims, **characterized by** drive means for driving the pressure transfer means.

8. Device according to Claim 7, **characterized in that** the drive means comprises a screw (20; 120) which acts on the pressure transfer means and which can be turned by a user in order to drive the pressure transfer means.

9. Device according to Claim 3, **characterized in that** the structural elements (1, 2) are designed to guide the pressure transfer means between the two structural elements (1, 2), wherein the pressure transfer means is situated in particular in a recess (7) in one of the structural elements (2) when the device is assembled.

10. Device according to one of the preceding claims, **characterized by** at least one viewing window (6; 106) for monitoring the removal of the at least one heatspreader.

11. Device according to one of the preceding claims, **characterized in that** the positioning means and the pressure transfer means at least partially consist of polyoxymethylene.

12. Device according to one of the preceding claims for simultaneously removing at least two heatspreaders from a respective microprocessor, **characterized in that**
- the positioning means is designed for positioning the at least two microprocessors with substrate, and
- the pressure transfer means is designed for simultaneously transferring a pressure onto the at least two heatspreaders.

13. Device according to one of the preceding claims for the automated removal of at least one heatspreader from a respective microprocessor with substrate and heatspreader, **characterized by**
- insertion and removal means for automatically inserting the at least one microprocessor with substrate and heatspreader into the positioning means and for automatically removing the at least one microprocessor with substrate after removing the heatspreader,
- driving means for automatically driving the pressure transfer device,
- in particular further comprising
∘ ejection means for automatically ejecting the at least one removed heatspreader
∘ control means for automatically controlling the insertion and removal means, drive means and ejection means, wherein the controller can have monitoring means, for example a camera, for monitoring the insertion of the at least one microprocessor with substrate and heatspreader, removing the at least one microprocessor with substrate, removing the at least one heatspreader and ejecting the at least one heatspreader.

14. Method for removing at least one heatspreader from a respective microprocessor which has a substrate and a heatspreader, with the use of a device according to one of the preceding claims, comprising the following steps:
- positioning the at least one microprocessor in a positioning means by virtue of the microprocessor and/or its substrate being fixed in a form-fitting manner by means of at least one recess (5, 13; 105) of the positioning means,
- transferring a pressure onto the at least one heatspreader by means of a pressure transfer means and thereby removing the at least one heatspreader,
- wherein the pressure is transferred in a guided manner by means of a guide for guiding the pressure transfer means, wherein
a) the positioning means has a structural element (101), wherein at least one microprocessor is releasably fixed between the structural element (101) and the pressure transfer means, or
b) the positioning means comprises at least two releasably interconnectable structural elements (1, 2), and the at least one microprocessor is fixable between the structural elements (1, 2) when the structural elements (1, 2) are interconnected, and
wherein the steps can be carried out in an automated manner.

## Revendications

1. Dispositif pour retirer au moins un revêtement thermoconducteur respectivement d'un microprocesseur, lequel possède un substrat et un revêtement thermoconducteur, comprenant
- un moyen de positionnement destiné à positionner l'au moins un microprocesseur, le moyen de positionnement comportant au moins un évidement (5, 13 ; 105) servant au positionnement du microprocesseur respectif et/ou de son substrat, par le biais duquel le microprocesseur respectif et/ou son substrat peuvent être fixés par complémentarité de formes,
- un moyen de transmission de pression destiné à transmettre une pression à l'au moins un revêtement thermoconducteur en vue d'enlever l'au moins un revêtement thermoconducteur et
- un élément de guidage destiné à guider le moyen de transmission de pression,
a) le moyen de positionnement possédant un élément structural (101) et l'au moins un microprocesseur pouvant être fixé de manière amovible entre l'élément structural (101) et le moyen de transmission de pression,
ou
b) le moyen de positionnement possédant au moins deux éléments structuraux (1, 2) pouvant être reliés l'un à l'autre de manière amovible et l'au moins un microprocesseur pouvant être fixé entre les éléments structuraux (1, 2) lorsque les éléments structuraux (1, 2) sont reliés l'un à l'autre.

2. Dispositif selon la revendication 1, **caractérisé en ce que** la pression peut être appliquée dans une direction, laquelle suit un tracé sensiblement parallèle à la surface du substrat de l'au moins un microprocesseur.

3. Dispositif selon la revendication 1 ou 2, **caractérisé en ce que** le moyen de positionnement possède l'élément de guidage.

4. Dispositif selon l'une quelconque des revendications précédentes, **caractérisé en ce que** l'élément de guidage est conçu pour guider le moyen de transmission de pression dans une direction sensiblement parallèle à la surface du substrat de l'au moins un microprocesseur.

5. Dispositif selon l'une quelconque des revendications précédentes, **caractérisé par** au moins un adaptateur (23, 24 ; 123), lequel peut être fixé de manière amovible dans le moyen de positionnement, l'adaptateur (23, 24 ; 123) comportant au moins l'un de l'au moins évidement (5, 13 ; 105) servant au positionnement du microprocesseur respectif et/ou de son substrat.

6. Dispositif selon l'une quelconque des revendications précédentes, **caractérisé en ce que** le moyen de transmission de pression possède un curseur (3).

7. Dispositif selon l'une quelconque des revendications précédentes, **caractérisé par** un moyen d'entraînement destiné à entraîner le moyen de transmission de pression.

8. Dispositif selon la revendication 7, **caractérisé en ce que** le moyen d'entraînement comporte au moins une vis (20 ; 120), laquelle agit sur le moyen de transmission de pression et laquelle peut être tournée par un utilisateur pour entraîner le moyen de transmission de pression.

9. Dispositif selon la revendication 3, **caractérisé en ce que** les éléments structuraux (1, 2) sont conçus pour guider le moyen de transmission de pression entre les deux éléments structuraux (1, 2), le moyen de transmission de pression se trouvant notamment dans un évidement (7) dans l'un des éléments structuraux (2) lorsque le dispositif est assemblé.

10. Dispositif selon l'une quelconque des revendications précédentes, **caractérisé par** au moins une fenêtre d'observation (6 ; 106) servant à la surveillance de l'enlèvement de l'au moins un revêtement thermoconducteur.

11. Dispositif selon l'une quelconque des revendications précédentes, **caractérisé en ce que** le moyen de positionnement et le moyen de transmission de pression se composent au moins partiellement de polyoxyméthylène.

12. Dispositif selon l'une quelconque des revendications précédentes pour retirer simultanément au moins deux revêtements thermoconducteurs respectivement d'un microprocesseur, **caractérisé en ce que**
- le moyen de positionnement est conçu pour le positionnement des au moins deux microprocesseurs avec le substrat, et
- le moyen de transmission de pression est conçu pour la transmission simultanée d'une pression sur les au moins deux revêtements thermoconducteurs.

13. Dispositif selon l'une quelconque des revendications précédentes pour le retrait automatisé d'au moins un revêtement thermoconducteur respectivement d'un microprocesseur avec substrat et revêtement thermoconducteur, **caractérisé par**
- un moyen de mise en place et d'enlèvement destiné à la mise en place automatisée de l'au moins un microprocesseur avec substrat et revêtement thermoconducteur après l'enlèvement du revêtement thermoconducteur,
- un moyen d'entraînement destiné à entraîner le moyen de transmission,
- comportant notamment en outre
∘ un moyen d'éjection servant à l'éjection automatisée de l'au moins un revêtement thermoconducteur enlevé
∘ un moyen de commande servant à la commande automatique du moyen de mise en place et d'enlèvement, du moyen d'entraînement et du moyen d'éjection, la commande pouvant posséder un moyen de surveillance, par exemple une caméra, destiné à la surveillance de la mise en place de l'au moins un microprocesseur avec substrat et revêtement thermoconducteur, de l'enlèvement de l'au moins un microprocesseur avec substrat, de l'enlèvement de l'au moins un revêtement thermoconducteur et de l'éjection de l'au moins un revêtement thermoconducteur.

14. Procédé pour retirer au moins un revêtement thermoconducteur respectivement d'un microprocesseur, lequel possède un substrat et un revêtement thermoconducteur, en utilisant un dispositif selon l'une quelconque des revendications précédentes, comprenant les étapes suivantes :
- positionnement de l'au moins un microprocesseur dans un moyen de positionnement, en fixant le microprocesseur et/ou son substrat par complémentarité de formes par au moins un évidement (5, 13 ; 105) du moyen de positionnement,
- transmission d'une pression à l'au moins un revêtement thermoconducteur par l'intermédiaire d'un moyen de transmission de pression et ainsi enlèvement de l'au moins un revêtement thermoconducteur,
- la pression étant transmise par l'intermédiaire d'un élément de guidage destiné à guider le moyen de transmission de pression,
a) le moyen de positionnement possédant un élément structural (101), l'au moins un microprocesseur étant fixé de manière amovible entre l'élément structural (101) et le moyen de transmission de pression, ou
b) le moyen de positionnement possédant au moins deux éléments structuraux (1, 2) pouvant être reliés l'un à l'autre de manière amovible et l'au moins un microprocesseur pouvant être fixé entre les éléments structuraux (1, 2) lorsque les éléments structuraux (1, 2) sont reliés l'un à l'autre, et
les étapes pouvant être exécutées de manière automatisée.
